# EUROPÄISCHE PATENTSCHRIFT

(11) **EP 2 566 999 B1**
(45) Veröffentlichungstag und Bekanntmachung des Hinweises auf die Patenterteilung: **12.12.2018**
(21) Anmeldenummer: 11716177.8
(22) Anmeldetag: 13.04.2011
(51) Int. Cl.: C23C 14/32, H01J 37/32

(54) **VERDAMPFUNGSQUELLE UND VERFAHREN ZUM FUNKENVERDAMPFEN MIT KERAMISCHEN TARGETS**
ARC SOURCE AND METHOD FOR SPARK DEPOSITION USING CERAMIC TARGETS
SOURCE D'ÉVAPORATION ET PROCÉDÉ POUR UNE ÉVAPORATION PAR ÉTINCELLE AVEC DES CIBLES CÉRAMIQUES

(30) Priorität: 04.05.2010 US 330935 P
(43) Veröffentlichungstag der Anmeldung: 13.03.2013
(73) Patentinhaber: Oerlikon Surface Solutions AG, Pfäffikon, 8808 Pfäffikon (CH)
(72) Erfinder: LECHTHALER, Markus, A-6800 Feldkirch (AT)
(74) Vertreter: Kempkens, Anke
(86) Internationale Anmeldenummer: PCT/EP2011/001856
(87) Internationale Veröffentlichungsnummer: WO 2011/137967

(56) Entgegenhaltungen:
- EP-A1- 1 862 565
- WO-A1-2009/038532
- DE-A1- 4 329 155
- JP-A- 1 042 575
- US-A1- 2001 035 348
- US-A1- 2008 110 749

## Beschreibung

### Technisches Gebiet auf das sich die Erfindung bezieht

Die vorliegende Erfindung betrifft ein Verfahren zur Beschichtung von Werkstücken mittels kathodischem Funkenverdampfen und elektrisch leitenden keramischen Targets. Die Erfindung betrifft insbesondere eine Quelle für eine Beschichtungsanlage zur Durchführung des oben genannten Verfahrens. Die Erfindung betrifft insbesondere eine Beschichtungsanlage zur Durchführung des oben genannten Verfahrens.

### Bisheriger Stand der Technik

Es ist bekannt Werkstücke dadurch zu beschichten, dass in einer Vakuumkammer ein Plasma in Form einer Hochstrom-Niederspannungs-Lichtbogenentladung auf einer Werkstoffquelle, im folgenden Target genannt, erzeugt wird. Der zu verdampfende Werkstoff wird bei diesem Prozess als Kathode an den negativen Pol einer Spannungsquelle gelegt. Mittels einer Zündeinrichtung wird der Lichtbogen gezündet. Der Lichtbogen schmilzt die Kathode an einem oder mehreren Kathodenflecken, in denen sich der Stromübergang konzentriert. Dabei werden im Wesentlichen Elektronen aus der Kathode herausgezogen. Um den Lichtbogen aufrecht zu erhalten, muss daher ständig für Elektronennachschub an der entsprechenden Kathodenoberfläche gesorgt werden. Der Lichtbogen, oder bedeutungsgleich auch Arc genannt, bewegt sich mehr oder weniger stochastisch auf der Kathodenfläche. Es kommt zu einem extrem schnellen Aufheizen kleiner Targetoberflächenbereiche, wodurch lokal Material verdampft wird. Dies ist bei metallischen Targetmaterialien kein Problem, da diese im Wesentlichen sowohl die Thermoschockbeständigkeit) als auch die Wärmeleitfähigkeit aufweisen um einen solchen durch den Lichtbogen induzierten punktuellen thermischen Schock unbeschadet zu überstehen.

Beim Funkenverdampfen von metallischen Targets spielt allerdings die Droplet-Problematik eine grosse Rolle: Durch das schnelle lokale Aufheizen des metallischen Targetmaterials werden makroskopische Spritzer, die von geschmolzenem Targetmaterial herrühren vom Target geschleudert die sich auf den zu beschichtenden Oberflächen als Droplet niederschlagen. Solche Droplets können Schichteigenschaften, wie zum Beispiel Verschleissbeständigkeit oder Oberflächenrauheit extrem negativ beeinflussen. Es wird daher viel Aufwand getrieben, um solche Droplets im Wesentlichen zu vermeiden. Eine Möglichkeit besteht darin, die Droplets, bevor sie sich am Substrat ablegen können herauszufiltern. Eine solche Massnahme ist allerdings aufwändig und hat meist negativen Einfluss auf die Beschichtungsrate. Da die Dropletbildung umso grösser ist, je langsamer sich der Lichtbogen auf der metallischen Targetoberfläche bewegt, gibt es auch die Möglichkeit die Dropletproblematik dadurch zu verringern, dass der Lichtbogen auf der Targetoberfläche, beispielsweise mittels horizontal radial ausgerichteter Magnetfeldlinien in eine schnelle Bewegung gezwungen wird. Die veröffentlichte Patentanmeldung WO200016373 offenbart dabei eine Konfiguration einer Beschichtungsquelle, bei der hinter dem metallischen Target magnetische Mittel vorgesehen sind die ausserhalb des Zentralbereichs des Targets zu einer solchen gewünschten Magnetfeldverteilung führt. Da im Zentralbereich des Targets vertikale Komponenten des Magnetfeldes vorherrschen, die quasi den Lichtbogen einfangen würden, wird dort mittels Abdeckung verhindert, dass der Lichtbogen dorthin gelangt. Als Abdeckung wird beispielsweise Bornitrid und /oder Titannitrid angegeben. Diese Materialien haben, wie dort beschrieben, eine geringere Sekundärelektronenemissionsrate und eine geringere Oberflächenenergie als das metallische Targetmaterial.

Die Patentanmeldung EP 1 862 565 A1 offenbart ein keramisches Target zum Funkenverdampfen.

Es sei hier angemerkt, dass im Rahmen der keramischen Targets die Dropletproblematik im Wesentlichen nicht gegeben ist. Bei keramischen Targets ist das Aufschmelzen des Targetmaterials durch den hohen Schmelzpunkt wesentlich komplexer als bei derartigen metallischen Verbindungen. Beim Verdampfen handelt es sich vermutlich viel eher um einen Sublimationsprozess. Die meisten der durch den Lichtbogen markoskopisch aus der keramischen Targetoberfläche herausgeschlagenen Stücke sind so gross, dass sie aufgrund der Gravitation nicht zu den zu beschichtenden Werkstücke gelangen sondern sich am Boden der Beschichtungskammer ablagern. Die auf den Werkstücken entstehende Schicht umfasst zwar noch messbar sogenannte Droplets. Diese allerdings in so geringer Dichte, dass keine weiteren Massnahmen gegen diese notwendig sind.

Demgegenüber ist ein grosses Problem darin zu sehen, dass Keramikmaterialien zumeist eine sehr geringe Thermoschockbeständigkeit aufweisen. Ist das Material nicht thermoschockbeständig, so entstehen Risse an denen der Kathodenfleck des Lichtbogens nur schwer vorbei kommt. Es ist noch nicht ganz geklärt, warum es an Rissen zu einem solchen Einfangen kommt. Eine mögliche Erklärung wäre mit Hilfe des sogenannten Feldemissionseffektes denkbar, bei dem es an Spitzen und Kanten zu einem erleichterten Elektronenaustritt kommt. Durch die längere Aufenthaltszeit erhitzt sich das Material dort zusätzlich, was bei keramischen Materialien zur Folge hat, dass die Schwelle für die Elektronenemission lokal sinkt. Dies bedeutet allerdings wiederum, dass der Lichtbogen, der sich immer diejenigen Bereiche der Oberfläche sucht, aus denen er am leichtesten Elektronen emittieren kann, noch länger am Riss verharrt. Es handelt sich dabei also um einen sich selbst verstärkenden zerstörerischen Effekt. Derzeit kommen daher beim Funkenverdampfen keramische Targets industriell im Wesentlichen nicht zum Einsatz. Eine Ausnahme hierzu bildet Wolframcarbid, dessen Thermoschockbeständigkeit im Vergleich zu anderen Keramikmaterialien insbesondere wie zum Beispiel Titannitrid (TiN), Titandiborid (TiB₂), ZrB2, NbB2 Wolframborid (WB) oder Wolrframnitrid (W2N) geringer ist Derzeit ist daher lediglich das Funkenverdampfen auf der Basis von Wolframcarbid-Targets (WC-Targets) verbreitet.

Es besteht allerdings ein Bedürfnis im Markt, auch solche Schichtmaterialien von keramischen Targets mittels Lichtbogen wirtschaftlich verdampfen zu können, für die dies bisher jedenfalls nicht in industriellem Massstab möglich war. Insbesondere sollen TiN, TiB₂, WB und/oder auch W₂N Targets für das Verdampfen mittels Lichtbogen herangezogen werden können, ohne dass es frühzeitig zum Targetbruch kommt.

Für TiB2 Targets wird dementsprechend im Artikel "ceramic cathodes for arc-physical vapor deposition: development and application", von O. Knotek, F. Löffler, surface and coating technology 49 (1991), Seiten 263 bis 267 von Problemen berichtet die die Konzentration des Kathodenflecks an einer lokalen Stelle konzentriert sieht was zur Überhitzung und sogar zum Bruch der Platte führt.

Der Erfindung liegt daher die Aufgabe zugrunde, auch solche Schichtmaterialien von keramischen Targets mittels Lichtbogen wirtschaftlich verdampfen zu können, für die dies bisher jedenfalls nicht in industriellem Massstab möglich war. Insbesondere sollen TiN, TiB₂, WB und/oder auch W₂N Targets für das Verdampfen mittels Lichtbogen herangezogen werden können, ohne dass es frühzeitig zum Targetbruch kommt.

Die Erfinder stellten sich daher die Frage, wie der durch den Arc auf das Target übertragene Thermoschock effizient abgefangen werden kann. Aus der Sputtertechnologie, welches ein zum Funkenverdampfen alternatives PVD-Beschichtungsverfahren ist, ist bekannt, das Sputter-Targetmaterial mit sogenannten Kühlplatten zu verkleben (bonden) um eine effiziente Wärmeabfuhr zu ermöglichen. Solche Kühlplatten haben eine grosse thermische Leitfähigkeit und werden möglichst breitflächig und mit guten Wärmebrücken an dem Sputter-Targetmaterial befestigt. Vorzugsweise haben diese Kühlplatten einen ähnlichen Ausdehnungskoeffizienten wie das für das Sputtern eingesetzte Targetmaterial. Aufgrund der hohen Targetleistungen beim Sputtern, bedingt durch die vergleichsweise hohe Entladungsspannung kommt es zu einem hohen thermischen Eintrag auf das Sputtertarget, allerdings gleichmässig verteilt über das ganze Target.

Die beim Funkenverdampfen auftretenden thermischen Belastungen die zu Thermoschocks führen können sind jedoch lokalisiert und zeichnen durch hohe Temperaturgradienten aus was zu einer mechanischen Überbeanspruchung des keramischen Targets führt. Im Gegensatz hierzu ist beim Sputtern die Thermoschockbeständigkeit durch die gleichmässige Temperaturverteilung im Target nicht relevant.

Der einfache Einsatz einer Kühlplatte beim für das Verdampfen mittels Lichtbogen eingesetzten keramischen Target führt daher nicht zu einem befriedigenden Ergebnis. Die Gefahr des Targetbruchs ist weiterhin prominent. Es kommt hinzu, dass die lokalisierte Temperaturbeaufschlagung häufig dazu führt, dass gerade dort lokal die Bondingverbindung Schaden nimmt und dann kein guter Wärmekontakt mehr besteht wo er eigentlich am notwendigsten wäre.

Allerdings haben die Erfinder herausgefunden, dass überraschenderweise einige Massnahmen, welche im Zusammenhang mit dem Funkenverdampfen von metallischen Targets zu eine Reduktion der Dropletproblematik führt, im Zusammenhang mit den keramischen Targets dazu führt, dass zuverlässig und ohne Beschädigung des keramischen und mit einer Kühlplatte versehenen Targets das Funkenverdampfen angewandt werden kann. Erfindungsgemäss wird daher das Funkenverdampfen derart vollzogen, dass von einem keramischen Target, an dessen Rückseite eine Kühlplatte gebondet ist, mittels Lichtbogen verdampft wird, dadurch gekennzeichnet dass der Lichtbogen auf eine schnelle Bewegung auf der Targetoberfläche gezwungen wird.

Eine erfindungsgemässe Lichtbogenquelle für Beschichtungsanlagen zum Lichtbogenverdampfen nach Anspruch 1 umfasst daher mindestens ein keramisches Target, an dessen Rückseite mit gutem thermischen Kontakt, vorzugsweise gebondet, eine Kühlplatte vorgesehen ist, dadurch gekennzeichnet dass in der Anlage Mittel vorgesehen sind, mittels derer der Kathodenfleck des Lichtbogens zu einer Bewegung gezwungen wird, welche die lokale Erwärmung und dadurch die Bildung von Mikrorissen reduzieren und selbst im Falle der Bildung kleiner Mikrorissen die an dieser Stelle erhöhte Aufenthaltswahrscheinlichkeit des Kathodenflecks verhindern.

Die Erfindung wird nachfolgend anhand von Zeichnungen beispielsweise näher erläutert. Dabei zeigen:
Fig. 1 eine erfindungsgemässe Quelle mit erfindungsgemässer Targetplatte in schematischer Seitenansicht.
Fig. 2 zeigt eine Ausführungsform eines erfindungsgemässen Bestandteils der Lichtbogenquelle.
Fig. 3 zeigt eine weitere eine Ausführungsform eines erfindungsgemässen Bestandteils der Lichtbogenquelle.

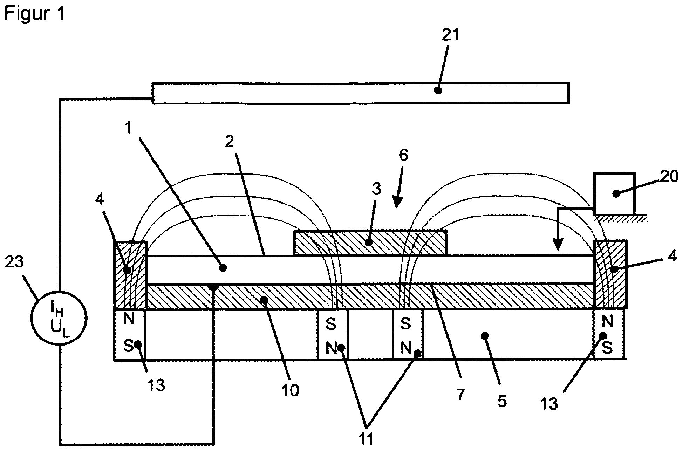

In Fig. 1 ist eine erfindungsgemässe Lichtbogen-Verdampferquelle dargestellt, wie sie in einer Arc-Verdampfungs-Kammer zur Beschichtung von Substraten verwendet wird. Sie umfasst üblicherweise eine Zündeinrichtung 20 - wie rein schematisch dargestellt - zum Zünden des Lichtbogens. Im weiteren ist zwischen Targetplatte 1 und einer Anode 21, wieder rein schematisch dargestellt, eine elektrische Hochstrom - I_{H} - , Niederspannungs - U_{L} - DC-Spannungsquelle 23 geschaltet.

Die erfindungsgemässe Lichtbogen-Quelle umfasst die elektrisch leitende keramische Targetplatte 1 mit zu verdampfender Oberfläche 2. An der rückseitigen Oberfläche 7 der Targetplatte 1, d.h. an der von der zu verdampfenden Oberfläche 2 abgewandten Oberfläche ist mit der Targetplatte 1 thermisch grossflächig wirkverbunden eine Kühlplatte 10 vorgesehen. Die Kühlplatte 10 besteht aus einem Material mit hoher thermischen Leitfähigkeit. Durch den grossflächigen thermischen Kontakt ist die Kühlplatte in der Lage den durch den Kathodenfleck auf die Targetoberfläche 2 erfolgenden lokalen Energieeintrag rasch und effizient über die gesamten Targetquerschnitt zu verteilen. Die Gefahr einer Zerstörung der Targetplatte 1 aufgrund Thermoschock ist somit bereits durch diese Vorkehrung etwas abgemildert. Ist die Kühlplatte zusätzlich elektrisch leitfähig so kann der elektrische Kontakt der Targetplatte 1 zur Spannungsquelle 23 über die Kühlplatte 10 realisiert sein. Beispielsweise kommt als Kühlplattenmaterial Molybdän in Frage, aber auch andere Materialien, wie aus der Sputtertechnologie bekannt, können verwendet werden.

Vorzugsweise ist die thermische Wirkverbundenheit dadurch hergestellt, dass die Kühlplatte an die Targetplatte gebondet ist. Allerdings hat sich gezeigt, dass es trotz Kühlplatte lokal zu einer Erwärmung kommt, welche dazu führt, dass lokal Elektronen leichter austreten können. Ohne weitere Massnahmen verharrt der Fleck daher an dieser Stelle, was dazu führt, dass der Thermoschock Grössenordungen annimmt, die selbst die Kühlplatte nicht mehr abfangen kann.

Die erfindungsgemässe Lichtbogenquelle umfasst daher ausserdem Mittel welche den Kathodenfleck bzw. gegebenenfalls die Kathodenflecken des Lichtbogens zu einer Bewegung über das Target und gegebenenfalls weg von Mikrorissen zwingen. In der in Fig. 1 gezeigten Ausführungsform umfassen diese Mittel hinter der Kühlplatte angeordnete innere Permanentmagneten 11 und einen äusseren Ringmagneten 13 welcher zu den inneren Permanentmagneten 11 gegenpolig orientiert ist. Aufgrund der inneren Permanentmagneten 11 und dem äusseren Ringmagneten 13 gibt es über der zu verdampfenden Oberfläche 2 von Nord nach Süd bzw. von Süd nach Nord verlaufende Magnetfeldlinien.. Horizontale Komponenten des über der Oberfläche 2 aufgebauten Magnetfeldes führen zu einer Zwangsbewegung des Kathodenflecks des Lichtbogens über die Oberfläche 2. Demgegenüber führen im vorliegenden Fall vertikale Komponenten des über der Oberfläche 2 aufgebauten Magnetfeldes dazu, dass der Kathodenfleck oder die Kathodenflecken des Lichtbogens im Wesentlichen auf der entsprechenden Stelle der Oberfläche verharrt oder dass dessen Bewegung zumindest abgebremst wird.

In der hier diskutierten Ausführungsform der vorliegenden Erfindung werden daher Massnahmen ergriffen, um den Kathodenfleck von Bereichen der Oberfläche 2 fernzuhalten, an welchen vertikale Komponenten des Magnetfeldes vorherrschen. Daher ist an der Oberfläche 2 der elektrisch leitenden keramischen Targetplatte 1 eine Abdeckung 3 in einem zentralen Bereich angeordnet, wobei die Abdeckung 3 so beschaffen ist, dass in diesem Bereich kein Elektronennachschub mehr gewährleistet ist, welcher am Kathodenfleck den Lichtbogen speisen könnte. Im vorliegenden Beispiel besteht zumindest die Oberfläche der Abdeckung 3 aus nicht leitendem Material, wie zum Beispiel Al₂O₃ oder Bornitrid. Denkbar ist allerdings auch, die Abdeckung 3 zwar aus leitendem Material anzufertigen, diese allerdings von der Spannungsquelle 23 zu isolieren oder zumindest in schlechterem elektrischen Kontakt mit der Spannungsquelle 23 zu bringen. Damit mit einer solchen Anordnung wird der Elektronennachschub verhindert oder zumindest stark gehemmt.

Der Kathodenfleck des Lichtbogens wird vorzugsweise dort hinwandern wo für genügend Elektronennachschub gesorgt ist und damit den zentralen Bereich 6, in dem vertikale Komponenten des Magnetfeldes vorherrschen, meiden.

Es sind unterschiedliche erfindungsgemässe Anordnungen denkbar und der Fachmann wird, angepasst an seine Problematik die für ihn am besten sich eignende Realisierung wählen.

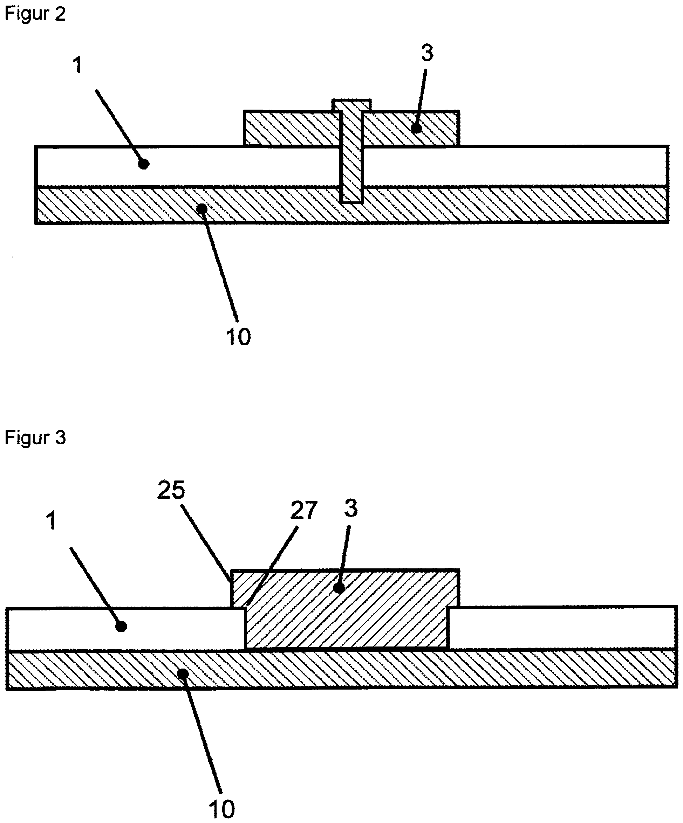

Figur 2 zeigt schematisch eine Targetplatte 1 mit gebondeter Kühlplatte 10. Die Targetplatte weißt eine zentrale Bohrung und die Kühlplatte 10 weißt ein Innengewinde auf, so dass eine erfindungsgemässe Abschirmung 3 mittels einer ebenfalls gezeigten Schraube 15 an die Kombination aus Targetplatte 1 und Kühlplatte 10 geschraubt werden kann.

Figur 3 zeigt eine weitere erfindungsgemässe Ausführungsform einer Targetplatte 1 mit gebondeter Kühlplatte 10 und Abschirmung 3. In dieser Ausführungsform ist die Abschirmung 3 in ein grossflächiges Loch der Targetplatte 1 eingelassen. Vorzugsweise gibt es, wie gezeigt einen kleinen Übergang der Abschirmung 3 über die Targetplatte 1 um zu vermeinden, dass der Kathodenfleck in die Nähe einer Kante der Targetplatte 1 gerät und dort quasi gefangen wird.

## Patentansprüche

1. Lichtbogen-Verdampfungsquelle umfassend:
- eine Kathode mit einer elektrisch leitenden keramischen Targetplatte (1) mit zu verdampfender Oberfläche (2)
- eine Anode (21)
- eine Spannungsquelle (23), welche mit der Targetplatte (1) und der Anode (21) so verschaltet ist, dass Targetplatte (1) gegenüber der Anode (21) auf negatives Potential gelegt werden kann
- eine Zündvorrichtung (20) zur Zündung des Lichtbogens
wobei die Targetplatte (1) mit einer Kühlplatte (10) grossflächig thermisch wirkverbunden ist und Mittel zur gezwungenen Bewegung des Kathodenflecks vorgesehen sind,
**dadurch gekennzeichnet, dass**:
• diese Mittel hinter der Kühlplatte (10) angeordnete innere Permanentmagneten (11) und einen äusseren Ringmagnete (13) umfasst, welcher zu den inneren Permanentmagneten (11) gegenpolig orientiert ist, wobei aufgrund der inneren Permanentmagneten (11) und des äusseren Ringmagneten (13) über der zu verdampfenden Oberfläche (2) von Nord nach Süd bzw. von Süd nach Nord verlaufende Magnetfeldlinien vorhanden sind, wobei horizontale Komponenten des über der Oberfläche (2) aufgebauten Magnetfeldes zu einer Zwangsbewegung eines Kathodenflecks eines Lichtbogens über die Oberfläche (2) führen können,
• die Kühlplatte (10) and die Targetplatte (1) gebondet ist, und
• an der Oberfläche (2) der elektrisch leitenden keramischen Targetplatte (1) eine Abschirmung (3) am zentralen Bereich (6) angeordnet ist, um den Kathodenfleck von Bereichen der Oberfläche (2) fernhalten zu können, an welchen vertikale Komponenten des Magnetfeldes vorherrschen, und
• wobei die Oberfläche der Abschirmung (3) von der Spannungsquelle (23) elektrisch isoliert ist und somit beim Betreiben der Verdampfungsquelle in diesem Bereich kein Elektronennachschub zur Verfügung steht.

2. Lichtbogen-Verdampfungsquelle gemäss Anspruch 1, **dadurch gekennzeichnet, dass** die Targetplatte (1) eine zentrale Bohrung und die Kühlplatte (10) ein Innengewinde aufweist, so dass die Abschirmung (3) mittels einer Schraube (15) an die Kombination aus Targetplatte (1) und Kühlplatte (10) geschraubt ist.

3. Lichtbogen-Verdampfungsquelle gemäss Anspruch 1, **dadurch gekennzeichnet, dass** die Abschirmung (3) in ein grossflächiges Loch der Targetplatte (1) eingelassen ist.

4. Lichtbogen-Verdampfungsquelle gemäss Anspruch 3, **dadurch gekennzeichnet, dass** ein Übergang der Abschirmung (3) über die Targetplatte (1) vorhanden ist, um zu vermeiden, dass der Kathodenfleck in die Nähe einer Kante der Targetplatte (1) gerät und dort gefangen wird.

5. Lichtbogen-Verdampfungsquelle gemäss einem der vorangehenden Ansprüche 1 bis 4, **dadurch gekennzeichnet, dass** als Kühlplattenmaterial Molybdän verwendet wird.

6. Beschichtungsanlage zum Beschichten von Substraten mit zumindest einer Lichtbogen-Verdampfungsquelle gemäss einem der vorangehenden Ansprüche.

7. Verfahren zur Beschichtung von Substraten, **dadurch gekennzeichnet, dass** zur Beschichtung eine Beschichtungsanlage gemäss Anspruch 6 eingesetzt wird.

## Claims

1. Arc deposition source, comprising:
- a cathode with an electrically conductive ceramic target plate (1) with a surface to be vaporized (2),
- an anode (21),
- a voltage supply source (23), which is interconnected with the target plate (1) and the anode (21) in such a manner that the target plate (1) opposite the anode (21) can be put to negative potential,
- an ignition device (20) for igniting the arc,
wherein the target plate (1) is operatively connected thermally with a cooling plate (10) over a large area and means are provided for constraining the movement of the cathodic spot,
**characterized in that**
• these means comprise inner permanent magnets (11) arranged behind the cooling plate (10) and an outer ring magnet (13) that is oriented with opposing polarity to the inner permanent magnets (11), wherein, due to the inner permanent magnets (11) and the outer ring magnets (13), magnetic field lines are provided that run over the surface (2) to be vaporized from north to south resp. from south to north, wherein horizontal components of the magnetic field formed over the surface (2) can lead to a constrained movement of a cathode spot of an arc over the surface (2),
• the cooling plate (10) is bonded to the target plate (1), and
• a shield (3) is provided in the central area (6) on the surface (2) of the electrically conductive ceramic target plate (1) in order to keep the cathode spot away from areas of the surface (2) at which vertical components of the magnetic field predominate,
• wherein the surface of the shield (3) is electrically isolated from the voltage supply source (23) and thus during operation of the deposition source no electron supply is available in this area.

2. Arc deposition source according to claim 1, **characterized in that** the target plate (1) has a central boring and the cooling plate (10) has an inner threading so that the shield (3) can be screwed onto the combination of target plate (1) and cooling plate (10) by means of a screw (15).

3. Arc deposition source according to claim 1, **characterized in that** the shield (3) is embedded in a large-size hole in the target plate (1).

4. Arc deposition source according to claim 3, **characterized in that** a transition from the shield (3) over the target plate (1) is provided in order to prevent the cathode spot from getting into the vicinity of an edge of the target plate (1) and being trapped there.

5. Arc deposition source according to one of the preceding claims 1 to 4, **characterized in that** molybdenum is used as material for the cooling plate.

6. Coating facility for coating substrates with at least one arc deposition source according to one of the preceding claims.

7. Method for coating substrates, **characterized in that** a coating facility according to claim 6 is used for the coating.

## Revendications

1. Source d'évaporation par arc comprenant:
- une cathode ayant une plaque de cible (1) céramique et électriquement conductrice avec une surface (2) à évaporer
- une anode (21)
- une source de tension (23) qui est interconnectée à la plaque de cible (1) et à l'anode (21) de telle manière que la plaque de cible (1) opposée à l'anode (21) peut être mise à potentiel négatif
- un dispositif d'allumage (20) pour allumer l'arc,
la plaque de cible (1) étant reliée thermiquement de façon opérationnelle sur une grande surface à une plaque de refroidissement (10) et des moyens sont prévus pour contraindre un mouvement de la tache cathodique, **caractérisé en ce que**:
• ces moyens comprennent des aimants permanents intérieurs (11) disposés derrière la plaque de refroidissement (10) et un aimant annulaire extérieur (13) qui est orienté de polarité opposée aux aimants permanents intérieurs (11), à cause des aimants permanents intérieurs (11) et l'aimaint annulaire extérieur (13) des lignes de champ magnétique étant présentes qui s'étendent sur la surface à évaporer (2) du nord au sud ou du sud au nord, des composants horizontaux du champ magnétique établi sur la surface (2) pouvant entraîner un mouvement contraint d'une tache cathodique d'un arc sur la surface (2),
• la plaque de refroidissement (10) est reliée à la plaque de cible (1), et
• sur la surface (2) de la plaque de cible (1) céramique et électriquement conductrice un blindage (3) est disposé dans la région centrale (6) pour tenir à distance la tache cathodique des régions de la surface (2) dans lesquelles des composants verticaux du champ magnétique prédominent, et
• la surface du blindage (3) étant isolé électriquement de la source de tension (23) et ainsi lors de l'utilisation de la source d'évaporation il n'y a aucun approvisionnement d'électrons dans cette région.

2. Source d'évaporation par arc selon la revendication 1 **caractérisée en ce que** la plaque de cible (1) comprend un alésage central et la plaque de refroidissement (10) comprend un taraudage intérieur de sorte que le blindage (3) peut être vissé au moyen d'un vis (15) à la combination constituée de la plaque de cible (1) et de la plaque de refroidissement (10).

3. Source d'évaporation par arc selon la revendication 1 **caractérisée en ce que** le blindage (3) est encastré dans un large trou de la plaque de cible (1).

4. Source d'évaporation par arc selon la revendication 3 **caractérisée en ce qu'**il y a une transition du blindage (3) sur la plaque de cible (1) pour éviter que la tache cathodique s'approche d'un bord de la plaque de cible (1) et y est capturée.

5. Source d'évaporation par arc selon l'une des revendications précédentes 1 à 4 **caractérisée en ce que** du molybdène est utilisé comme matériau de la plaque de refroidissement.

6. Installation de revêtement pour revêtir des substrats ayant du moins une source d'évaporation par arc selon l'une des revendications précédentes.

7. Procédé de revêtement de substrats **caractérisé en ce qu'**une installation de revêtement selon la revendication 6 est utilisée pour le revêtement.
